# NEW EUROPEAN PATENT SPECIFICATION

(11) **EP 1 272 264 B2**
(45) Date of publication and mention of the opposition decision: **15.07.2009**
(45) Mention of the grant of the patent: 04.10.2006
(21) Application number: 01917362.4
(22) Date of filing: 02.04.2001
(51) Int. Cl.: B01J 3/06

(54) **HIGH TEMPERATURE/HIGH PRESSURE COLOUR CHANGE OF DIAMOND**
HOCHTEMPERATUR/HOCHDRUCK-FARBEVERÄNDERNG VON DIAMANTEN
CHANGEMENT SOUS HAUTE PRESSION/TEMPERATURE ELEVEE DE LA COULEUR D'UN DIAMANT

(30) Priority: 31.03.2000 GB 0007887
(43) Date of publication of application: 08.01.2003
(73) Proprietor: Element Six Technologies (PTY) LTD, Nuffield Springs (ZA)
(72) Inventor: BURNS, Robert, Charles, 2195 Northcliff (ZA); FISHER, David, Maidenhead, Berkshire SL6 5EP (GB); SPITS, Raymond Anthony, 2194 Bordeaux (ZA)
(74) Representative: Talbot-Ponsonby, Daniel Frederick
(86) International application number: PCT/IB2001/000525
(87) International publication number: WO 2001/072404

(56) References cited:
- WO-A-01/14050
- WO-A-01/14050
- WO-A-01/33203
- GB-A- 1 578 987
- US-B- 6 692 714
- ALAN T. COLLINS ET AL.: "Colour changes produced in natural brown diamonds by high-pressure, high-temperature treatment" DIAMOND AND RELATED MATERIALS, vol. 9, no. 2, March 2000 (2000-03), pages 113-122, XP004195517 AMSTERDAM., NL ISSN: 0925-9635
- K. SCHMETZER : "BEHANDLUNG NATUERLICHER DIAMANTEN ZUR REDUZIERUNG DER GELB- ODER BRAUNSAETTIGUNG" GOLDSCHMIEDE ZEITUNG, vol. 97, no. 5, 1999, pages 47-48, XP000997186 stuttgart, de ISSN: 0017-1689
- A. V. NIKITIN ET AL.: "The Effect of Heat and Pressure on Certain Physical Properties of Diamonds" SOVIET PHYSICS - DOKLADY, vol. 13, no. 7, January 1969 (1969-01), pages 842-844, XP001019666 New York, US
- S. C. LAWSON & H. KANDA: "Nickel in Diamond: An Annealing Study" DIAMOND AND RELATED MATERIALS., vol. 2, 1993, pages 130-135, XP001015642 ELSEVIER SCIENCE PUBLISHERS, AMSTERDAM., NL ISSN: 0925-9635
- T. EVANS & P. RAINEY: "CHANGES IN THE DEFECT STRUCTURE OF DIAMOND DUE TO HIGH TEMPERATURE +HIGH PRESSURE TREATMENT" PROCEEDINGS OF THE ROYAL SOCIETY OF LONDON, vol. 344, 1975, pages 111-130,A,B, XP000965244 London, GB ISSN: 0080-4649
- T.M.MOSES ET AL.: 'Observations on GE processed Diamonds:A Photographic Record' GEMS & TECHNOLOGY vol. 35, no. 3, 1999, pages 14 - 22
- MARTIN RAPAPORT: 'GE/LKI Support-Disclosure and Detection, interview with Leon Tempelsman of LKI' 04 October 1999, Retrieved from the Internet: <URL:www.diamonds.net> [retrieved on 1999-10-04]
- GEMKEY: 'LKI/GE Process announced at GemFest Asia 99' calendar/hongkong/hkday3 Retrieved from the Internet: <URL:www.gemkey.com> [retrieved on 1999-09-27]
- MARTIN RAPAPORT: 'GE Using Technology to Perfect Nature, interview with Bill Woodburn of GE' 01 October 1999, news/printmsg Retrieved from the Internet: <URL:www.diamonds.net>
- J. VAN ROYEN ET AL.: 'Diamond: Natural, treated or synthetic?' ANTWERP FACETS vol. 32, 06 September 1999, pages 6 - 15
- A.T.COLLINS ET AL.: 'Colour Changes produced in natural brown diamonds by high-pressure,high-temperature treatment' DIAMOND AND RELATED MATERIALS vol. 9, 2000, pages 113 - 122
- 'Properties and Applications of Diamond', 1991, BUTTERWORTH-HEINEMANN article WILKS AND WILKS
- 'Collecting and Classifying Coloured Diamonds', 1998, ASHLAND PRESS, NEW YORK article S.C.HOFER, pages 294 - 352
- 'Gemological Insitute of America Certifications nr 10468056(09.10.98) and nr 10516366 (08.12.98)' 09 October 1998,
- D.FISHER, R.A.SPITS: 'Spectroscopic Evidence of GE POL HPHT-Treated Natural Type IIa Diamonds' GEMS & GEMOLOGY 2000,
- M.B.KIRKLEY ET AL.: 'Age,Origin, and Emplacement of Diamonds: Scientific Advances in the Last Decade' GEMS & GEMOLOGY 1991, pages 2 - 25
- 'North Holland Series on Crystal Growth', 1973, NORTH HOLLAND PUBLISHING COMPANY article ED.P.HARTMAN, pages 460 - 461
- T.COLLINS: 'Colour Centries in Diamond' J GEMM vol. 1, no. 37, 1982, pages 37 - 69
- PROCEEDINGS OF THE INTERNATIONAL GEMOLOGICAL SYMPOSIUM 20 June 1991, LOS ANGELES, page 159
- R.BARNES ET AL,: 'Combined TEM and STEM study of the brown colouration of natural diamonds' JOURNAL OF PHYSICS:CONFERENCE SERIES 26 2006, pages 157 - 160
- L.S.HOUNSOME ET AL.: 'Optical properties of vacancy related defects in diamond' PHYS.STAT.SOL. vol. 202, no. 11, 2005, pages 2182 - 2187
- A.S.BIDNY ET AL.: 'The SEM and CCL-SEM Study of Graphitic Inclusions in Natural Brown Diamonds' THE AUSTRALIAN GEMMOLOGIST vol. 23, 2007, MOSCOW, pages 126 - 130
- 'Gem Trade Lab Notes' GEMS & GEMOLOGY vol. 35, no. 4, 1999, pages 203 - 204
- T.TEMPLEMAN RAPAPORT vol. 23, no. 1, 07 January 2000, pages 28 - 30

## Description

### BACKGROUND OF THE INVENTION

The present invention relates to a method of changing the colour of a diamond, including the steps of creating a reaction mass by providing the diamond in a pressure transmitting medium which completely encloses the diamond, and subjecting the reaction mass to high temperature and pressure for a suitable period of time.

Diamonds are generally classified into four main types: Ia, Ib, IIa and IIb. These types are usually distinguished by infrared and ultraviolet spectra. Type Ia and Ib diamonds contain nitrogen in a combination of different forms. Type Ib contains single substitutional nitrogen or C-centres. Ia contains a combination of various nitrogen structures. Type IIa diamonds have a nitrogen content of less than a few parts per million (ppm) and can be defined as those diamonds which show substantially no absorption in the 1332 - 400 cm⁻¹ range when irradiated with infrared radiation. Type IIa diamond can exhibit a brown colour caused, it is believed, by structural deformation within the diamond crystal lattice.

US 4, 124,690 describes a process for converting type Ib nitrogen into type la nitrogen in type Ib diamond by high temperature annealing under a pressure which prevents graphitisation. This treatment has the effect of reducing the yellow colour of the type Ib diamond.

### SUMMARY OF THE INVENTION

The present invention provides a method as set forth in Claim 1. The remaining claims claim preferred or optional features of the invention.

### DESCRIPTION OF EMBODIMENTS

In the present invention, a brown type IIa diamond crystal, which will generally be natural diamond, is annealed under a pressure which prevents significant graphitisation in order to modify the structural deformation which gives rise to the brown colouration and thereby reduce the brown colour and produce or enhance the pink colour of the diamond. A pink diamond is produced.

Pink natural diamonds are rare. Thus, the present invention provides a method of producing or enhancing the pink colour of a natural type IIa diamond without causing damage to the diamond crystal.

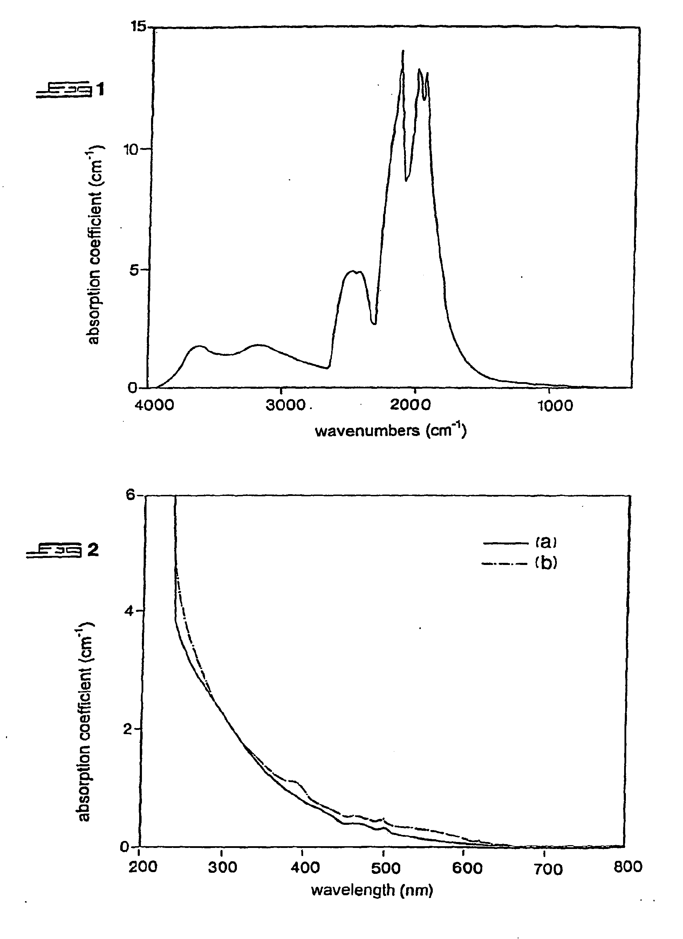

The typical infrared absorption spectrum of a type IIa diamond is shown in Figure 1. However, it is not all type IIa diamonds which are suitable for colour enhancement by high temperature and high pressure treatment of the present invention. The diamonds must have a brown colour which can vary from deep to light brown, including e.g. pinkish brown. Those type IIa diamonds that are suitable for the present invention have a nitrogen concentration of less than 2 ppm, preferably less than 0,2 ppm, exhibit a brown to pinkish brown colour and have a typical ultraviolet / visible absorption spectrum, which shows a monotonically rising absorption with broad bands centred about 390 and 550 nm as shown in Figure 2 in graph line b.

The brown diamond is converted to a pink diamond using an annealing temperature ranging from about 1900°C to about 2300°C, and preferably 2100°C to 2300°C, under a pressure ranging from 6,9GPa to 8,5GPa and preferably about 7,4GPa to 8,5GPa, for a period generally ranging from 10 minutes to 10 hours, and preferably 20 minutes to 4 hours. Generally, the higher the annealing temperature, the shorter the annealing time. Examples of particularly suitable annealing conditions, within the pressure ranges identified above are:
2200 - 2300°C for 1 hour
2300°C for a period of less than 4 hours and preferably 1 hour.
2100°C for 1 hour.

The change in colour of the type IIa diamond crystal can be quantified by the changes in the absorption spectrum of the crystal taken before and after annealing. Spectra are taken of the crystal at room temperature by means of a spectrometer in a conventional manner showing the ultraviolet / visible absorption spectrum of the crystal. After the crystal is annealed, spectra are taken of it again at room temperature.

Subjecting such diamonds to the method of this invention results in a reduction of strength of the monotonically rising absorption and the enhancement of the strength of the broad absorption bands at 390 and 550 nm; this results in the enhanced pink colour.

In the method of the invention, a reaction mass is created by providing diamond in a pressure transmitting medium which completely encloses a diamond. The pressure transmitting medium is preferably a homogeneous pressure transmitting medium which evenly spreads the pressure which is applied over the entire surface of the diamond which is being treated. Examples of suitable mediums are those which have a low shear strength such as metal halide salts. Examples of suitable metal halide salts are potassium bromide, sodium chloride, potassium chloride, caesium chloride, caesium bromide, copper chloride and copper bromide. Such mediums have been found to provide the desirable even spread of pressure which ensures that any graphitisation which may occur on the diamond surface is kept to a minimum. A particular advantage of using a metal halide salt as the pressure transmitting medium is that the diamonds can be easily recovered after treatment by dissolving the medium in hot water.

The method of the invention may be used to treat a single diamond or a plurality of discrete diamonds. If a plurality of discrete diamonds are treated simultaneously, each diamond should be separated from its neighbours by the pressure transmitting medium. The maximum volume of diamond which may be treated is limited only by the capacity of the high pressure/high temperature apparatus used.

Conventional high temperature/high pressure apparatus may be used in the method of the invention. Various reaction vessel configurations which provide for indirect or direct heating of the reaction mass are disclosed in the patent literature and are useful in carrying out the present annealing process. These reaction vessels usually consist of a plurality of interfitting cylindrical members and end plugs or discs for containing the reaction mass in the centremost cylinder. In the indirectly heated type of reaction vessel one of the cylindrical members is made of graphite which is heated by the passage of electric current therethrough and which thereby heats the reaction mass. In the directly heated type of reaction vessel, the reaction mass is electrically conductive, thereby eliminating the need for an electrically conductive graphite cylinder, and electric current is passed directly through the reaction mass to heat it.

### EXAMPLE 1 (ILLUSTRATIVE OF HPHT PROCESS)

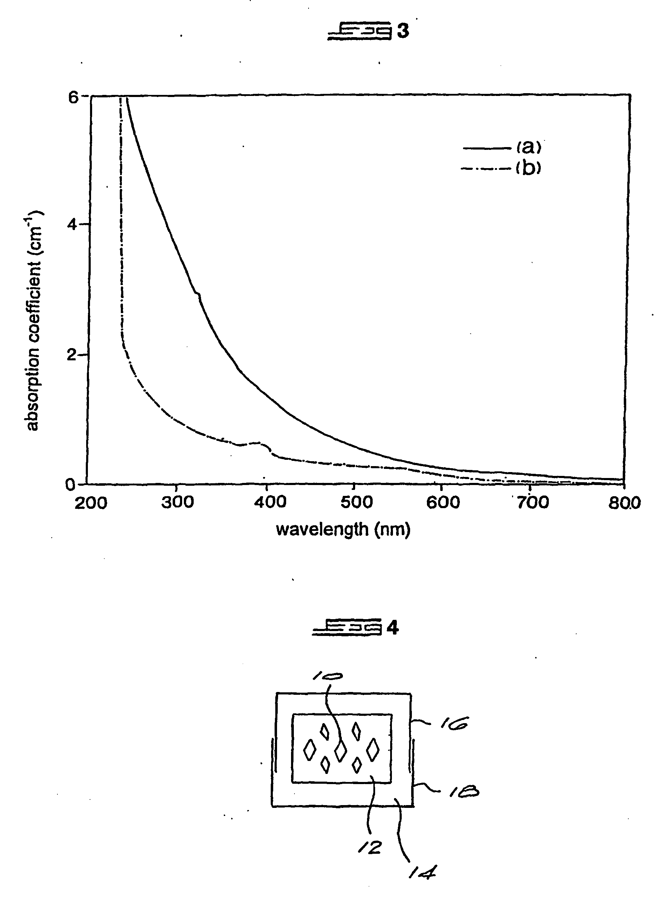

A natural brown type IIa diamond, with the ultraviolet / visible absorption spectrum before treatment shown in Figure 3 in graph line a (i.e. not in accordance with the present invention), was used. A plurality of such diamonds were placed in a pressure transmitting medium in a reaction vessel of the type illustrated by Figure 4. Referring to this figure, the diamond crystals 10 are placed in a pressure transmitting medium 12 such that the crystals are discrete and separated from each other in the pressure transmitting medium. The diamonds are preferably evenly dispersed in the medium. The pressure transmitting medium is preferably a low shear strength medium of the type described above. The diamond-containing medium 12 is placed in a container 14 made from graphite, pyrophyllite, magnesium oxide or zirconium oxide which is enclosed by co-operating metal cups 16, 18 which form a metal canister around the container 14. The metal may be molybdenum, tantalum or steel. The canister may be compacted around the container to eliminate air voids. The loaded canister is now placed in the reaction zone of a conventional high temperature/high pressure apparatus. The contents of the capsule were subjected to a temperature of 2250°C and a pressure of 7,8GPa which conditions were maintained for a period of 4 hours. The capsule was removed from the apparatus and allowed to cool. The canister and graphite container were removed and the diamonds recovered from the medium. The ultraviolet / visible absorption spectrum of the diamond after treatment is shown in Figure 3 in graph line b. The spectrum shows the presence of the broad bands at 390 and 550 nm which give rise to the pink colouration which was observed.

## Claims

1. A method of changing the colour of a brown type IIa diamond, including the steps of:
i) creating a reaction mass by providing the diamond in a pressure transmitting medium which completely encloses the diamond; and
ii) subjecting the reaction mass to high temperature and pressure for a suitable period of time;
**characterised in that**:
the diamond has a nitrogen concentration of less than 2 ppm, exhibits brown to pinkish brown colour and has an ultraviolet/visible absorption spectrum which shows a monotonically rising absorption with broad bands centred about 390 and 550 nm;
the colour of the diamond is changed from brown to pink; and
the reaction mass is subjected to a temperature in the range of 1900°C to 2300°C under a pressure of 6.9 GPa to 8.5 GPa.

2. A method according to claim 1, wherein the diamond is natural diamond.

3. A method according to claim 1 or 2, wherein the nitrogen concentration is less than 0.2 ppm.

4. A method according to any of the preceding claims, wherein the diamond has an ultraviolet/visible absorption spectrum which, after the diamond has been subjected to step (ii), has a reduction of strength of the monotonically rising absorption, and an enhancement of the strength of the broad absorption bands centred about 390 and 550 nm.

5. A method according to any of the preceding claims, wherein the temperature in step (ii) is in the range 2100°C to 2300°C.

6. A method according to any of the preceding claims, wherein the pressure in step (ii) is in the range 7.4 GPa to 8.5 GPa.

7. A method according to any of the preceding claims, wherein the period during which the diamond is subjected to the conditions of step (ii) is in the range 10 minutes to 10 hours.

8. A method according to any of the claims 1 to 6, wherein the period during which the diamond is subjected to the conditions of step (ii) is in the range 20 minutes to 4 hours.

9. A method according to any of the preceding claims, wherein a plurality of diamonds is placed in the pressure transmitting medium, each diamond being separated from its neighbour by pressure transmitting medium.

10. A method according to any of the preceding claims, wherein the pressure transmitting medium is a homogeneous medium which completely encloses the or each diamond and is applied over the entire surface of the diamond.

11. A method according to any of the preceding claims, wherein the pressure transmitting medium has a low shear strength.

12. A method according to any of the preceding claims, wherein the pressure transmitting medium is water soluble.

13. A method according to any of the preceding claims, wherein the pressure transmitting medium is a metal halide salt.

14. A method according to claim 13, wherein the halide is bromide or chloride.

15. A method according to any of claims 1 to 10, wherein the pressure transmitting medium is potassium bromide.

16. A method according to any of claims 1 to 10, wherein the pressure transmitting medium is sodium chloride.

17. A method according to any of claims 1 to 10, wherein the pressure transmitting medium is potassium chloride. '

18. A method according to any of claims 1 to 10, wherein the pressure transmitting medium is caesium chloride.

19. A method according to any of claims 1 to 10, wherein the pressure transmitting medium is caesium bromide.

20. A method according to any of claims 1 to 10, wherein the pressure transmitting medium is copper chloride.

21. A method according to any of claims 1 to 10, wherein the pressure transmitting medium is copper bromide.

## Patentansprüche

1. Verfahren zur Änderung der Farbe eines braunen Diamanten vom Typ IIa, mit den folgenden Schritten:
i) Erzeugen einer Reaktionsmasse durch Bereitstellen des Diamanten in einem druckübertragenden Medium, das den Diamanten vollständig einschließt; und
ii) Einwirkenlassen einer hohen Temperatur und eines hohen Drucks auf die Reaktionsmasse während eines geeigneten Zeitraums;
**dadurch gekennzeichnet, dass**:
Der Diamant eine Stickstoffkonzentration von weniger als 2 ppm, braune bis rosabraune Farbe und ein Absorptionsspektrum im ultravioletten/sichtbaren Bereich mit einer monoton ansteigenden Absorption mit breiten Banden aufweist, die um etwa 390 nm und 550 nm zentriert sind;
die Farbe des Diamanten von braun nach rosa verändert wird; und
die Reaktionsmasse einer Temperatur im Bereich von 1900°C bis 2300°C unter einem Druck von 6,9 GPa bis 8,5 GPa ausgesetzt wird.

2. Verfahren nach Anspruch 1, wobei der Diamant ein Naturdiamant ist.

3. Verfahren nach Anspruch 1 oder Anspruch 2, wobei die Stickstoffkonzentration weniger als 0,2 ppm beträgt.

4. Verfahren nach einem beliebigen der vorstehenden Ansprüche, wobei der Diamant ein Absorptionsspektrum im ultravioletten/sichtbaren Bereich aufweist, das, nachdem der Diamant dem Schritt (ii) ausgesetzt worden ist, eine Verminderung der monoton ansteigenden Absorptionsstärke und eine Erhöhung der Stärke von breiten Absorptionsbanden aufweist, die um etwa 390 nm und 550 nm zentriert sind.

5. Verfahren nach einem beliebigen der vorstehenden Ansprüche, wobei die Temperatur im Schritt (ii) im Bereich von 2100°C bis 2300°C liegt.

6. Verfahren nach einem beliebigen der vorstehenden Ansprüche, wobei der Druck im Schritt (ii) im Bereich von 7,4 bis 8,5 GPa liegt.

7. Verfahren nach einem beliebigen der vorstehenden Ansprüche, wobei der Zeitraum, während dessen der Diamant den Bedingungen von Schritt (ii) ausgesetzt wird, im Bereich von 10 Minuten bis zu 10 Stunden liegt.

8. Verfahren nach einem beliebigen der Ansprüche 1 bis 6, wobei der Zeitraum, während dessen der Diamant den Bedingungen von Schritt (ii) ausgesetzt wird, im Bereich von 20 Minuten bis 4 Stunden liegt.

9. Verfahren nach einem beliebigen der vorstehenden Ansprüche wobei mehrere Diamanten in das druckübertragende Medium eingebracht werden, wobei jeder Diamant durch druckübertragendes Medium von seinem Nachbarn getrennt ist.

10. Verfahren nach einem beliebigen der vorstehenden Ansprüche, wobei das druckübertragende Medium ein homogenes Medium ist, das den oder jeden Diamanten vollständig einschließt und über der gesamten Oberfläche des oder jedes Diamanten aufgebracht wird.

11. Verfahren nach einem beliebigen der vorstehenden Ansprüche, wobei das druckübertragende Medium eine niedrige Scherfestigkeit aufweist.

12. Verfahren nach einem beliebigen der vorstehenden Ansprüche, wobei das druckübertragende Medium wasserlöslich ist.

13. Verfahren nach einem beliebigen der vorstehenden Ansprüche, wobei das druckübertragende Medium ein Metallhalogenidsalz ist.

14. Verfahren nach Anspruch 13, wobei das Halogenid Bromid oder Chlorid ist.

15. Verfahren nach einem der Ansprüche 1 bis 10, wobei das druckübertragende Medium Kaliumbromid ist.

16. Verfahren nach einem der Ansprüche 1 bis 10, wobei das druckübertragende Medium Natriumchlorid ist.

17. Verfahren nach einem der Ansprüche 1 bis 10, wobei das druckübertragende Medium Kaliumchlorid ist.

18. Verfahren nach einem der Ansprüche 1 bis 10, wobei das druckübertragende Medium Cäsiumchlorid ist.

19. Verfahren nach einem der Ansprüche 1 bis 10, wobei das druckübertragende Medium Cäsiumbromid ist.

20. Verfahren nach einem der Ansprüche 1 bis 10, wobei das druckübertragende Medium Kupferchlorid ist.

21. Verfahren nach einem der Ansprüche 1 bis 10, wobei das druckübertragende Medium Kupferbromid ist.

## Revendications

1. Procédé de changement de la couleur d'un diamant de type IIa brun, comprenant les étapes consistant à:
i) créer une masse réactionnelle en mettant le diamant dans un milieu de transmission de pression qui entoure complètement le diamant; et
ii) soumettre la masse réactionnelle à une température et à une pression élevée pendant une période de temps appropriée;
**caractérisé en ce que** :
le diamant a une concentration d'azote inférieure à 2 ppm, présente une couleur brune à brune rosâtre et possède un spectre d'absorption ultraviolet/visible qui présente une absorption croissante monotone avec des bandes larges centrées autour de 390 et 550 nm ;
la couleur du diamant change du brun au rose, et
la masse réactionnelle est soumise à une température dans le domaine de 1900°C à 2300°C sous une pression de 6,9 GPa à 8,5 GPa.

2. Procédé selon la revendication 1, dans lequel le diamant est un diamant naturel.

3. Procédé selon la revendication 1 ou la revendication 2, dans lequel la concentration d'azote est inférieure à 0,2 ppm.

4. Procédé selon l'une quelconque des revendications précédentes, dans lequel le diamant possède un spectre d'absorption ultraviolet/visible qui, après que le diamant ait été soumis à l'étape (ii), présente une réduction de force de l'absorption croissante monotone, et une amélioration de la force des bandes d'absorption larges centrées autour de 390 et 550 nm.

5. Procédé selon une quelconque des revendications précédentes, dans lequel la température dans l'étape (ii) est dans le domaine de 2100°C à 2300°C.

6. Procédé selon une quelconque des revendications précédentes, dans lequel la pression dans l'étape (ii) est dans le domaine de 7,4 GPa à 8,5 GPa.

7. Procédé selon une quelconque des revendications précédentes, dans lequel la période durant laquelle le diamant est soumis aux conditions de l'étape (ii) est dans le domaine de 10 minutes à 10 heures.

8. Procédé selon une quelconque des revendications 1 à 6, dans lequel la période durant laquelle le diamant est soumis aux conditions de l'étape (ii) est dans le domaine de 20 minutes à 4 heures.

9. Procédé selon une quelconque des revendications précédentes, dans lequel une pluralité de diamants est placée dans le milieu de transmission de pression, chaque diamant étant séparé de son voisin par le milieu de transmission de pression.

10. Procédé selon une quelconque des revendications précédentes, dans lequel le milieu de transmission de pression est un milieu homogène qui entoure complètement le ou chaque diamant et est appliqué sur toute la surface du diamant.

11. Procédé selon une quelconque des revendications précédentes, dans lequel le milieu de transmission de pression possède une faible résistance au cisaillement.

12. Procédé selon une quelconque des revendications précédentes, dans lequel le milieu de transmission de pression est soluble dans l'eau.

13. Procédé selon une quelconque des revendications précédentes, dans lequel le milieu de transmission de pression est un sel d'halogénure métallique.

14. Procédé selon la revendication 13, dans lequel l'halogénure est du bromure ou du chlorure.

15. Procédé selon une quelconque des revendications 1 à 10, dans lequel le milieu de transmission de pression est du bromure de potassium.

16. Procédé selon une quelconque des revendications 1 à 10, dans lequel le milieu de transmission de pression est du chlorure de sodium.

17. Procédé selon une quelconque des revendications 1 à 10, dans lequel le milieu de transmission de pression est du chlorure de potassium.

18. Procédé selon une quelconque des revendications 1 à 10, dans lequel le milieu de transmission de pression est du chlorure de césium.

19. Procédé selon une quelconque des revendications 1 à 10, dans lequel le milieu de transmission de pression est du bromure de césium.

20. Procédé selon une quelconque des revendications 1 à 10, dans lequel le milieu de transmission de pression est du chlorure de cuivre.

21. Procédé selon une quelconque des revendications 1 à 10, dans lequel le milieu de transmission de pression est du bromure de cuivre.
